(19) Europäisches Patentamt
European Patent Office
Office européen des brevets

(11) EP 1 081 855 B1

(12) **FASCICULE DE BREVET EUROPEEN**

(45) Date de publication et mention de la délivrance du brevet:
**28.01.2004 Bulletin 2004/05**

(51) Int Cl.[7]: **H03J 7/02**, H04L 27/233, H04L 7/08

(21) Numéro de dépôt: **00402405.5**

(22) Date de dépôt: **31.08.2000**

(54) **Procédé et dispositif de synchronisation d'un recepteur de communication**

Verfahren und vorrichtung zur synchronisation eines kommunikationsempfängers

Synchronization method and apparatus of a communication receiver

(84) Etats contractants désignés:
**AT BE CH CY DE DK ES FI FR GB GR IE IT LI LU MC NL PT SE**

(30) Priorité: **02.09.1999 FR 9911013**

(43) Date de publication de la demande:
**07.03.2001 Bulletin 2001/10**

(73) Titulaire: **NORTEL NETWORKS France**
**78117 Châteaufort (FR)**

(72) Inventeurs:
- **Belveze, Fabrice Jean-André**
**78310 Maurepas (FR)**
- **Chancel, Florence Madeleine**
**78000 Versailles (FR)**

(74) Mandataire: **Loisel, Bertrand**
**Cabinet Plasseraud**
**65/67 rue de la Victoire**
**75440 Paris Cedex 09 (FR)**

(56) Documents cités:
**EP-A- 0 892 528**

- **MAZZENGA F ET AL: "BLIND LEAST-SQUARES ESTIMATION OF CARRIER PHASE, DOPPLER SHIFT, ANDDOPPLER RATE FOR M-PSK BURST TRANSMISSION" IEEE COMMUNICATIONS LETTERS,US,IEEE SERVICE CENTER, PISCATAWAY,US, vol. 2, no. 3, 1 mars 1998 (1998-03-01), pages 73-75, XP000751863 ISSN: 1089-7798**
- **CAIRE G ET AL: "A NEW SYMBOL TIMING AND CARRIER FREQUENCY OFFSET ESTIMATION ALGORITHM FOR NONCOHERENT ORTHOGONAL M-CPFSK" IEEE TRANSACTIONS ON COMMUNICATIONS,US,IEEE INC. NEW YORK, vol. 45, no. 10, 1 octobre 1997 (1997-10-01), pages 1314-1326, XP000723127 ISSN: 0090-6778**
- **HITOSHI YOSHINO ET AL: "AN EQUALIZER WITH CARRIER-ACQUISITION-DURING-TRAINING (CAT) ALGORITHM FOR MOBILE RADIO" ELECTRONICS & COMMUNICATIONS IN JAPAN, PART I - COMMUNICATIONS,US,SCRIPTA TECHNICA. NEW YORK, vol. 75, no. 5, 1 mai 1992 (1992-05-01), pages 98-108, XP000311472 ISSN: 8756-6621**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 1 081 855 B1

## Description

La présente invention concerne le domaine des communications numériques.

On considère un schéma de transmission numérique classique (figure 1) : le signal reçu, consistant en une séquence de symboles, est issu d'un modulateur numérique 1, puis éventuellement déformé par un canal de propagation 2.

Dans de nombreux systèmes, le récepteur 3 nécessite deux informations de synchronisation temporelle : la « date » des frontières entre symboles (pour le fonctionnement du démodulateur), ce qui donne une information de synchronisation *modulo* la durée d'un symbole ; et une « horloge » système, dont la précision est en nombres entiers de temps symbole, par exemple matérialisée par une frontière entre « trames » si le signal émis possède cette structure (pour bénéficier, par exemple, de la présence de séquences d'apprentissage à des instants précis, et/ou pour savoir où aller décoder ensuite les informations voulues). Cette horloge est indiquée par un ou des symboles particuliers qui jouent le rôle de repères, et que le récepteur doit découvrir.

De plus, le signal reçu doit être correctement situé dans le domaine fréquentiel, attendu par le démodulateur 4 du récepteur 3. Or, les oscillateurs du récepteur et de l'émetteur ayant une précision limitée, on peut s'attendre à un décalage fréquentiel qu'il convient de corriger.

L'organe de synchronisation 5 schématisé sur la figure 1 est appelé en premier par le récepteur. Il délivrera les deux informations (temporelle et fréquentielle). L'information temporelle sera alors utilisée directement par le démodulateur / décodeur 4, qui décalera ses références pour atteindre à la fois la position correcte des symboles ainsi que l'information utile. L'information fréquentielle sera exploitée par un circuit de correction 6 pour corriger de façon analogique ou numérique la position fréquentielle du signal reçu. L'organe 5 met en oeuvre un algorithme ayant pour objectif d'estimer le décalage en fréquence et de retrouver la structure temporelle de l'information.

Le premier critère important de performance de la synchronisation est la fiabilité des informations temporelle et fréquentielle obtenues. Un second critère est le coût nécessaire pour obtenir ces informations (temps d'exécution, mémoire et de puissance de calcul nécessaires). Il existe plusieurs familles de méthodes de synchronisation :

- les méthodes en aveugle, couramment appelées NDA (« *Non Data Aided* »), qui ne nécessitent pas la connaissance par le récepteur d'une partie de l'information transmise (grâce à l'utilisation de propriétés du signal émis, le plus souvent). La plupart de ces méthodes, que ce soit pour estimer l'écart fréquentiel ou temporel, reposent sur le passage du signal par des non-linéarités qui provoquent des raies grâce auxquelles on peut se synchroniser (voir J.B. Anderson et al., « Digital Phase Modulation », Plenum Press, 1986). D'ailleurs, on trouve toute une famille de solutions analogiques (PLL, boucle de Costas, ..., voir J.C. Bic et al., « Eléments de communications numériques », Tome 1, Collection CNET/ENST, Dunod, 1986). L'inconvénient est que ces techniques sont spécialisées par type de modulation, et ne donnent pas d'horloge système d'un niveau plus élevé que le temps symbole ;
- pour la synchronisation système, des solutions à base de codes (notamment de codes convolutifs) ayant des propriétés intéressantes d'autocorrélation. Ceci nécessite bien entendu une synchronisation préalable fréquentielle et temporelle au niveau symbole.
- les méthodes sur trame connue (DA, « *Data Aided »),* où le récepteur connaît tout ou partie d'une trame permettant d'estimer les informations de synchronisation. Dans le cas du système de radiocommunication cellulaire GSM, une fréquence particulière, c'est-à-dire un signal purement sinusoïdal, sert pour la synchronisation fréquentielle, puis une séquence dédiée (burst) permet la synchronisation temporelle. Un autre exemple est décrit dans FR-A-2 745 134.

Les méthodes DA présentent l'inconvénient de faire baisser le débit utile, puisqu'une partie du signal ne transporte pas d'information à proprement parler. Il faut toutefois noter que les méthodes NDA ne sont pas toujours applicables selon la nature du signal, c'est-à-dire du codeur à l'émission. Les méthodes sont alors très spécifiques. Il existe notamment de nombreuses méthodes (voir par exemple : A. D'Andrea et al., « A Digital Approach to Clock Recovery in Generalized Minimum Shift Keying », IEEE Transactions on Vehicular Technology, Vol. 39, No. 3, août 1990 ; A. D'Andrea et al., « frequency Detectors for CPM Signals », IEEE Transactions on Communications, Vol. 43, No. 2-3-4, février/mars/avril 1995) applicables lorsque le codeur est un modulateur CPM (« *Continuous Phase Modulation* »), qui ne s'appliquent pas aux autres types de modulation. En outre, leurs performances en matière de temps d'exécution, mesurées par la durée pour aboutir aux informations fiables de synchronisation, sont parfois médiocres. Les méthodes DA peuvent se révéler plus efficaces en termes de durée d'exécution, pour une même fiabilité, pour une diminution du débit utile négligeable. De plus, elles sont totalement générales, et ne dépendent pas de la nature du signal utilisé.

Il existe donc un besoin pour un processus de synchronisation délivrant, dans un laps de temps relativement court, les informations de position temporelle et fréquentielle de l'information. Ce processus doit fonctionner pour des

décalages fréquentiels et/ou temporels relativement élevés, dans la limite de la bande utile et pour n'impcrte quel temps d'arrivée du signal utile. La perte d'information utile liée à la durée d'exécution de la synchronisation et/ou à l'insertion de données connues doit être négligeable par rapport au débit utile. De plus, il est souhaitable que ce processus ne soit pas trop coûteux en temps de calcul, et fasse donc essentiellement intervenir des opérations simples (additions, multiplications).

La méthode habituelle pour acquérir la synchronisation fréquentielle dans le cas de modulations CPM d'indice k/p (J.B. Anderson et al., « Digital Phase Modulation », Plenum Press, 1986) est une méthode en aveugle (NDA) consistant à calculer la transformée de Fourier du signal reçu en bande de base élevé à la puissance p, et à détecter des raies dans le spectre ainsi obtenu. Des raies de fréquence $\Delta f + i/(2T_s)$ apparaissent en principe dans ce spectre, $\Delta f$ étant l'écart de fréquence à estimer, $T_s$ la durée d'un symbole et i un entier. Mais leur détection est parfois problématique : elles peuvent être noyées dans la densité spectrale de puissance du signal à la puissance p ou dans le bruit capté par le récepteur, et il peut y avoir une incertitude sur l'entier i valable pour une raie détectée. Ceci dépend des caractéristiques de la CPM employée : les méthodes NDA sont parfois inutilisables.

La présente invention a pour but de répondre au besoin précité, particulièrement en ce qui concerne les aspects de synchronisation fréquentielle. Les applications visées sont notamment les récepteurs de communications numériques nécessitant un organe de synchronisation pour amorcer le décodage de l'information, et pour lesquels les méthodes NDA sont impossibles ou peu performantes.

Selon l'invention, il est proposé un procédé de synchronisation d'un récepteur de communication, dans lequel on évalue un écart entre une fréquence de modulation, combinée à un premier signal en bande de base pour former un signal émis sur un canal de propagation et une fréquence employée par le récepteur pour former un second signal en bande de base à partir d'un signal reçu sur le canal de propagation, et on corrige la fréquence employée par le récepteur en fonction de l'écart évalué. Connaissant un segment temporel du premier signal en bande de base et la position temporelle d'un segment correspondant du second signal en bande de base, lesdits segments comprenant N échantillons à une fréquence d'échantillonnage $F_e$, on calcule une transformée en fréquence Y(f), de taille N, du produit du complexe conjugué dudit segment du premier signal en bande de base par le segment correspondant du second signal en bande de base, et on évalue ledit écart de fréquence $\Delta f$ comme étant celui pour lequel la transformée en fréquence Y(f) est la plus proche de $C.S_c(f-\Delta f)$, où $S_c(f)$ est la fonction

$$S_c(f) = \frac{1-\exp(-2j\pi Nf/F_e)}{1-\exp(-2j\pi f/F_e)},$$

et C est un coefficient complexe.

Dans une réalisation particulière, l'évaluation de l'écart de fréquence comprend :

- la détermination d'une fréquence $f_{max}$ qui maximise la quantité $|Y(f)|^2$ parmi les N points de la transformée en fréquence, |.| désignant le module d'un nombre complexe ;
- une division de l'intervalle $[f_{max} - F_e /N, f_{max} + F_e /N]$ en plusieurs sous-intervalles ;
- une recherche dichotomique dans chacun des sous-intervalles pour identifier chaque fréquence $\delta f$ qui annule la quantité :

$$F(\delta f) = \mathrm{Re}\left\{\left\langle Y(f), S_c(f-\delta f)\right\rangle^{*}.\left\langle Y(f), \frac{\partial S_c(f-\delta f)}{\partial(\delta f)}\right\rangle\right\} \qquad (1)$$

où Re(.) et (.)* désignent respectivement la partie réelle et le conjugué d'un nombre complexe et, pour deux fonctions complexes de la fréquence A(f) et B(f), $\langle A(f),B(f-\delta f)\rangle$ désigne le produit scalaire :

$$\left\langle A(f), B(f-\delta f)\right\rangle = \sum_{i=0}^{N-1} \overline{A(f_i)}.B(f_i-\delta f)^{*} \qquad (2)$$

$f_i$ désignant le point de rang i de la transformée en fréquence ; et

- la sélection de l'écart de fréquence $\Delta f$ comme étant celle des fréquences $\delta f$ qui annule la quantité $F(\delta f)$ et pour laquelle la fonction coût :

$$K(\delta f) = \left\| Y(f) - \frac{\langle Y(f), S_c(f-\delta f)\rangle . S_c(f-\delta f)}{\|S_c(f-\delta f)\|^2} \right\|^2 \qquad (3)$$

est minimale, ‖.‖ étant la norme associée audit produit scalaire.

Ledit segment temporel du premier signal en bande de base peut ne pas être connu a priori par le récepteur. Lorsque le récepteur est synchronisé en temps et en fréquence et que l'on souhaite remettre à jour la synchronisation fréquentielle pour corriger éventuellement une légère dérive de l'oscillateur local, on peut ainsi utiliser le résultat de la démodulation et/ou du décodage en tant que « segment temporel du premier signal en bande de base » pour la mise en oeuvre du procédé.

Bien souvent, ledit segment temporel du premier signal en bande de base sera toutefois connu a priori par le récepteur, le procédé comprenant une phase de synchronisation temporelle pour obtenir la position temporelle dudit segment du second signal en bande de base.

La synchronisation fréquentielle exploite alors des segments de signal requis pour la synchronisation temporelle, ce qui permet de pallier les insuffisances des méthodes NDA généralement employées. Ces segments peuvent rester de taille modérée de sorte que la mise en oeuvre du procédé n'affecte pas trop la bande passante. Cette taille est égale ou supérieure au nombre N précité. La synchronisation fréquentielle est alors conditionnée par la réussite de la synchronisation temporelle, ce qui est peu pénalisant si la probabilité de réussite de la synchronisation temporelle est élevée.

Dans une réalisation préférée, le segment temporel connu a priori comprend plusieurs occurrences consécutives d'un premier motif de $L_c$ échantillons, et éventuellement un second motif plus long que le premier . La phase de synchronisation temporelle comprend une étape de d'estimation modulo $L_c$ par maximisation de la corrélation entre le second signal en bande de base et les occurrences consécutives du premier motif, et une étape de levée d'ambiguïté du modulo $L_c$, fournissant une synchronisation temporelle à la résolution des échantillons par maximisation de la corrélation entre le second signal en bande de base et le second motif.

Après avoir ainsi réalisé une première synchronisation temporelle produisant un nombre entier $n_{est}$ représentant un décalage temporel, en nombre d'échantillons, du second signal en bande de base par rapport audit segment temporel du premier signal en bande de base, on affine la première synchronisation temporelle en ajoutant au nombre entier $n_{est}$ la quantité :

$$\Delta\tau = 1 - \lambda . \frac{\mathrm{Re}\left\{ \sum_{q=0}^{N_c-1} \left[ \left( \sum_{k=0}^{L_{Sc}-1} r_{n_{est}+q.L_c+k} . x_k^{c*} \right) . \left( \sum_{k=0}^{L_{Sc}-2} r^*_{n_{est}+q.L_c+k} . dx_k^c \right) \right] \right\}}{\sum_{q=0}^{N_c-1} \left\| \sum_{k=0}^{L_{Sc}-1} r_{n_{est}+q.L_c+k} . x_k^{c*} \right\|^2} \qquad (4)$$

où λ est le facteur de normalisation prédéterminé :

$$\lambda = \frac{\left( \sum_{k=0}^{L_{Sc}-1} \left| x_k^c \right|^2 \right)^2}{\left( \sum_{k=0}^{L_{Sc}-1} \left| x_k^c \right|^2 \right) . \left( \sum_{k=0}^{L_{Sc}-1} \left| dx_k^c \right|^2 \right) - \left[ \mathrm{Im} \left( \sum_{k=0}^{L_{Sc}-1} x_k^c . dx_k^{c*} \right) \right]^2} \qquad (5)$$

$N_c$ est le nombre d'occurrences consécutives du premier motif, $L_{Sc}$ est le nombre d'échantillons de la séquence répétitive formée par les occurrences consécutives du premier motif dans ledit segment temporel du premier signal en

bande de base, $r_{n_{est}+q.L_c+k}$ est l'échantillon de rang $n_{est}$+q.$L_c$+k du second signal en bande de base, $x_k^c$ est l'échantillon de rang k de ladite séquence répétitive, $dx_k^c$ est l'échantillon de rang k d'une séquence formée par la dérivée temporelle de ladite séquence répétitive, et Im(.) désigne la partie imaginaire d'un nombre complexe.

Un autre aspect de la présente invention se rapporte à un dispositif de synchronisation d'un récepteur de communication, comprenant des moyens d'analyse d'un signal reçu, agencés pour mettre en oeuvre un procédé tel que défini ci-dessus.

D'autres particularités et avantages de la présente invention apparaîtront dans la description ci-après d'exemples de réalisation non limitatifs, en référence aux dessins annexés, dans lesquels :

- la figure 1, précédemment commentée, est un schéma synoptique d'une chaîne de transmission numérique ;
- la figure 2 montre un exemple de réalisation d'un modulateur d'un émetteur radio numérique ;
- la figure 3 est un schéma synoptique d'un récepteur associé, ayant un module de synchronisation pour la mise en oeuvre de l'invention ; et
- la figure 4 est un organigramme d'une procédure mise en oeuvre par ce module de synchronisation.

L'invention est illustrée ci-après dans une application particulière aux radiocommunications avec des terminaux mobiles. On comprendra que cet exemple ne limite aucunement le champ d'application de l'invention.

Dans cet exemple particulier, l'information transmise est découpée en trames de 20 ms. Le modulateur numérique représenté sur la figure 2 fonctionne selon une modulation de type CPM quaternaire, d'indice de modulation 1/3, dont l'impulsion de phase

$$\left(q(t) = \int_{-\infty}^{t} g(u)du \Big/ 2.\int_{-\infty}^{+\infty} g(u)du\right)$$

est par exemple définie par où $\lambda_1$ = 0,5,

$$g(t) = \frac{\sin(\lambda_1\pi(t-LT_s / 2))}{\lambda_1\pi(t-LT_s / 2)} \times \frac{\sin(\lambda_2\pi(t-LT_s / 2))}{\lambda_2\pi(t-Lt_s / 2)},$$

$\lambda_2$ = 0,77 et L = 4, $T_s$ désignant la durée d'un symbole. Les symboles transmis, notés $\alpha_i$ , sont dans l'ensemble {-3,-1,+1,+3}. Ils sont transmis au débit $1/T_s$ = 8000 symboles par seconde. Le signal complexe en bande de base s'écrit classiquement x(t) = exp[j$\varphi$(t)], avec

$$\varphi(t) = \frac{2\pi}{3}\sum_{i=0}^{[t/T_s]} \alpha_i.q(t-iT_s).$$

Cette modulation CPM peut être décrite par un treillis comportant 3 états de phase (0, $2\pi/3$ , $-2\pi/3$ aux temps-symbole pairs, et $\pi$, $-\pi/3$, $\pi/3$ aux temps-symbole impairs) et 4 transitions par état (correspondant aux quatre symboles possibles).

Dans la réalisation montrée sur la figure 2, le filtre 10 applique l'impulsion de phase q(t) au train de symboles $\alpha_i$. Les cosinus et sinus de la phase résultante $\varphi$(t), formant respectivement les parties réelle et imaginaire du signal en bande de base x(t), sont fournis par un module 11, échantillonnés à une fréquence $F_e$ = 16 KHz (deux échantillons complexes par temps-symbole).

Deux multiplieurs 12 modulent respectivement deux ondes radio en quadrature de fréquence $f_0$, délivrées par un oscillateur local 13, par les parties réelle et imaginaire du signal en bande de base x(t) converties en analogique. Les deux ondes modulées sont sommées en 14 pour former le signal radio amplifié et émis par l'antenne 15.

Le canal de propagation 2 associé est un canal à évanouissements, dit canal de Rayleigh. Le démodulateur utilisé par le récepteur de la figure 3 peut reposer sur un algorithme de Viterbi classique fonctionnant selon le treillis précité (voir G. D. Fomey Jr., « The Viterbi Algorithm », Proc. of the IEEE, Vol. 61, No. 3, mars 1973, pages 268-278). Ce démodulateur nécessite d'être synchronisé temporellement et fréquentiellement.

Le signal radio reçu par l'antenne 16 et amplifié est soumis à deux multiplieurs 17 recevant deux ondes en

quadrature de fréquence $f_0 + \Delta f$, délivrées par un oscillateur local 18. Les sorties des multiplieurs 17 forment un signal complexe traité par un filtre passe-bas 19, dont la fréquence de coupure correspond à la bande utile du signal, par exemple 6 kHz. Le signal complexe en bande de base r(t) disponible en sortie du filtre 19 est échantillonné à la fréquence $F_e$ et numérisé, en aval ou en amont du filtre 19 selon que celui-ci est réalisé sous forme analogique ou numérique. On note $r_n$ ce signal en bande de base échantillonné, n étant l'index des échantillons. Le signal numérique $r_n$ est adressé à une unité de synchronisation 20 et au démodulateur 21 qui produira les estimations $\hat{\alpha}_i$ des symboles transmis.

Le décalage fréquentiel $\Delta f$ peut être dû aux imprécisions de l'oscillateur local 13 de l'émetteur et/ou de celui 18 du récepteur. Il existe d'autre part un décalage temporel $\tau$ entre l'émetteur et le récepteur, dû au temps de propagation inconnu. Le signal en bande de base r(t) obtenu dans l'étage radio du récepteur peut être exprimé en fonction de celui x(t) formé par l'émetteur :

$$r(t) = C.x(t-\tau).\exp(2j\pi\Delta f.t)+b(t) \tag{6}$$

où C est un coefficient complexe représentant l'atténuation et le déphasage introduits par le canal de propagation et b(t) du bruit additif.

On suppose que dans l'exemple considéré, le décalage temporel $\tau$ est limité en valeur absolue à 10 ms, et que le décalage fréquentiel $\Delta f$ ne peut dépasser, toujours en valeur absolue, 5 kHz.

Si le décalage fréquentiel $\Delta f$ est excessif (proche de sa valeur limite), on perd une part importante de l'énergie utile en raison du filtrage opéré en 19. Il est alors nécessaire d'effectuer une première synchronisation fréquentielle grossière permettant de réduire ce décalage.

1) SYNCHRONISATION FREQUENTIELLE GROSSIERE

Le récepteur ne peut couvrir une bande fréquentielle infinie ; celle-ci est limitée par des considérations matérielles (bande passante des composants) et peut être intentionnellement sélectionnée par des dispositifs de filtrage. En particulier, dans un système fonctionnant en accès multiple à répartition en fréquence (FDMA), on sélectionne le canal fréquentiel correspondant à la communication souhaitée. Cette restriction du domaine fréquentiel est effectuée dans le premier étage du récepteur (filtre 19 dans l'exemple représenté).

Qu'elle soit volontaire ou non, cette sélection fréquentielle peut avoir des conséquences néfastes sur les traitements du signal $r_n$ obtenu après ce premier étage. En effet, l'oscillateur générant la fréquence porteuse supposée présente une certaine imprécision, et la fréquence porteuse réelle du signal et celle utilisée par le récepteur ne peuvent être rigoureusement identiques. Si elles sont éloignées, le filtrage autour de la porteuse utilisée par le récepteur peut alors entraîner l'élimination d'une partie de l'énergie du signal utile, qui sera perdue pour les traitements ultérieurs.

On note cependant que les incertitudes sur les fréquences générées par les oscillateurs 13, 18 sont maîtrisables, et qu'on connaît souvent la valeur maximale possible pour le décalage entre la fréquence souhaitée et celle réellement modulée (5 kHz dans l'exemple considéré). Il demeure que ce décalage, s'il n'est pas négligeable devant la bande utile du signal transmis, peut affecter ce dernier d'une façon irrémédiable. La première synchronisation fréquentielle proposée vise à corriger grossièrement le décalage fréquentiel initial, pour le ramener à une valeur beaucoup plus faible.

Ce premier traitement est composé d'une estimation grossière du décalage fréquentiel et d'une correction réalisée dans le premier étage du récepteur, en analogique ou en numérique. Cette estimation offre l'intérêt d'être robuste aux forts décalages fréquentiels, même lorsqu'une grande partie de l'énergie du signal a disparu à cause du filtrage du récepteur.

La fenêtre de signal numérique observé $r_n$ de longueur $L_r$ ($n = 0, ..., L_r-1$) est le résultat de la transmission d'un signal $x_n$, inconnu du récepteur, bruité et déformé par le canal de propagation 2. La formule suivante donne une première estimation du décalage fréquentiel :

$$\Delta f_1 = \frac{F_e}{2\pi}\left[\mathrm{Arg}\left(\sum_{n=0}^{L_r-1} r_n^* . r_{n+1}\right) - \mathrm{Arg}\left(\sum_{n=0}^{L_r-1} x_n^* . x_{n+1}\right)\right] \tag{7}$$

où Arg(.) désigne l'argument d'un nombre complexe.

En effet, si le signal reçu est simplement le signal $x_n$ décalé fréquentiellement de $\Delta f$, la formule (7) donne bien $\Delta f_1 = \Delta f$. On note qu'un décalage temporel sur $x_n$ n'a aucune influence sur l'estimation $\Delta f_1$. La quantité

$$\sum_{n=0}^{L_r-1} x_n^* \cdot x_{n+1}$$

est une approximation de l'autocorrélation d'ordre 1 du signal émis $x_n$, approximation d'autant plus exacte que $L_r$ est grand. Cette autocorrélation est une propriété statistique du signal émis, calculable à l'avance. Seule la connaissance de l'argument de cette valeur est nécessaire au récepteur.

De plus, pour de nombreux types de signaux, en particulier les modulations CPM comme dans l'exemple ci-dessus, l'autocorrélation est réelle, et l'expression de $\Delta f_1$ ne dépend plus que du signal reçu $r_n$ (voir A. D'Andrea et al., « Digital Carrier Frequency Estimation For Multilevel CPM Signals », Proc. ICC'95, juin 1995). L'estimation grossière $\Delta f_1$ est alors simplement :

$$\hat{\Delta f_1} = \frac{F_e}{2\pi} \mathrm{Arg}\left(\sum_{n=0}^{L_r-1} r_n^* \cdot r_{n+1}\right) \qquad (8)$$

Cette estimation est effectuée par l'unité de synchronisation 20 à l'étape 30 de la figure 4. Si une correction de fréquence numérique, à savoir une multiplication du signal complexe non filtré par $e^{-2j\pi\Delta f_1}$, est prévue en amont du filtre 19, celle-ci peut être effectuée sur la fenêtre de signal courante en vue des traitements suivants (étape 31 de la figure 4). Sinon (cas illustré par la figure 3), les autres traitements de synchronisation sont effectués sans correction de fréquence grossière, et celle-ci sera (éventuellement) prise en compte pour les fenêtres suivantes par rectification analogique de la fréquence de l'oscillateur 18 (étape 40).

Des simulations ont montré que, dans l'exemple considéré, quelles que soient les conditions de propagation, et pour des décalages fréquentiels initiaux dans [-5, +5] kHz, le décalage résiduel après cette correction grossière n'est jamais supérieur à 1500 Hz.

Après la correction fréquentielle grossière, le décalage fréquentiel résiduel est beaucoup moins élevé, ce qui permet la synchronisation temporelle et fréquentielle fine décrite ci-dessous.

## 2) SYNCHRONISATION TEMPORELLE

La trame de synchronisation choisie dans l'exemple est un segment de référence de 10 ms inséré dans le flot des trames utiles, toutes les 500 ms. A chaque début de communication, l'unité 20 du récepteur lance l'algorithme de synchronisation qui s'arrête une fois la trame de synchronisation détectée et le traitement effectué.

Le segment de référence utilisé, d'une durée de 10 ms, est composé dans l'exemple considéré de $N_c = 3$ motifs courts, identiques et consécutifs, de 16 symboles chacun puis d'un motif long de 32 symboles. Le motif court correspond par exemple à la modulation de la suite de 16 symboles : {-3, -3, +1, -1, +1, +1, +1, -3, +1, -3, +3, +1, -3, -3, +3, +3}. Ce motif est donc composé de $L_c = 32$ échantillons prédéterminés. On note $x_k^c$ la séquence répétitive de ces échantillons ($0 \le k < L_{Sc} = N_c.L_c = 96$).

Le motif long correspond par exemple à la modulation de la suite de 32 symboles : {+3, -1, +1, +1, +1, -3, -3, -3, -3, -3, -1, -3, +1, +3, +3, -1, +1, +3, -3, -3, +3, +3, +3, +1, +3, -3, -3, +1, -1, +1, +1, -3}. Il est donc composé de $L_l = 64$ échantillons prédéterminés. On note $x_k^l$ la suite de ces échantillons ($0 \le k < L_l$).

On note enfin $x_k$ la suite des $N' = L_{Sc} + L_l = 160$ échantillons correspondant au segment de référence de 10 ms ($x_k = x_k^c$ si $k < L_{Sc}$, $x_k = x_{k-L_{Sc}}^l$ si $L_{Sc} \le k < N'$).

L'algorithme de synchronisation temporelle comporte trois étapes :

- un test de répétition pour tester la présence d'une zone répétitive correspondant à la succession de motifs courts ;
- un calcul de corrélation avec le motif court, pour estimer le décalage $\tau$ modulo $L_c$, suivi par un calcul de corrélation avec le motif long aux positions correspondant à la première estimation modulo $L_c$. Ce calcul donne l'estimation de « l'horloge système » et une information sur la vraisemblance de cette estimée ;
- une estimation fine procurant une résolution temporelle plus fine que $T_e = 1/F_e$ pour le décalage temporel $\tau$.

### 2.1) Test de répétition

Ce test 32 permet de s'assurer de la nature de la trame qu'on traite. En effet, selon la valeur du décalage

temporel et la mémoire disponible en réception, le signal observé peut ne pas contenir la trame de synchronisation. On peut alors utiliser la structure répétitive de la trame de synchronisation pour la reconnaître (l'information étant par hypothèse aléatoire et donc peu répétitive), et ainsi interrompre l'algorithme dès ce premier test si celui-ci n'est pas concluant. Ceci permet de diminuer la quantité moyenne de calculs à effectuer.

Le test 32 consiste à évaluer une autocorrélation normalisée du signal en bande de base $r_n$ relativement à un décalage temporel correspondant au décalage $L_c$ entre deux occurrences du motif court $x^c$ dans le segment de référence.

Pour reconnaître la trame de synchronisation, on effectue un calcul de répétition sur $L_c$ échantillons jusqu'à ce qu'on dépasse un seuil SR (par exemple SR ≈ 0,25). On calcule ainsi l'indicateur suivant, pour $1 \leq m < L_r/L_c$ :

$$rep(m) = \frac{\left|\sum_{k=0}^{L_c-1} r_{k+L_c(m-1)} \cdot r^*_{k+L_c m}\right|^2}{\sum_{k=0}^{L_c-1} \left|r_{k+L_c(m-1)}\right|^2 \cdot \sum_{k=0}^{L_c-1} \left|r_{k+L_c m}\right|^2} \qquad (9)$$

Si le seuil SR n'est jamais atteint par rep(m) sur la longueur du signal mémorisé (test 32 de la figure 4), la synchronisation échoue, et l'unité de synchronisation 20 commande simplement l'oscillateur 18 pour qu'il prenne en compte (éventuellement) la correction de fréquence représentée par l'estimation grossière $\Delta f_1$ pour la prochaine fenêtre d'observation du signal (étape 40). Si le test de répétition est satisfait, l'unité 20 recherche le segment de synchronisation.

On choisit une taille de fenêtre d'observation $L_r$ telle qu'on soit assuré de pouvoir acquérir entièrement la trame de synchronisation. Une solution préférée est une fenêtre de taille 2 fois celle du motif total de synchronisation, soit 20 ms ou $L_r$ = 320, dont la première moitié est la même que la seconde moitié de la fenêtre précédente, et dont la seconde moitié est la même que la première moitié de la fenêtre suivante. Le test de répétition sert alors uniquement à éviter le lancement intempestif de l'algorithme.

2.2.1) Calcul de l'estimation de $\tau$ modulo $L_c$

On recherche d'abord le motif court sur toute la longueur du signal observé, en se décalant progressivement de n = 0, 1, ... , $L_c$-1 échantillons, et de m fois la longueur d'un motif court (m = 0, 1, 2, ... ) jusqu'à ce que la fin de la zone de mémoire accessible soit atteinte. Cette recherche est effectuée grâce à un calcul de corrélations entre la portion de signal considérée et la partie du segment de référence correspondant à la succession de motifs courts. La corrélation C(n,m), indexée par n et m avec $0 \leq n < L_c$ et $0 \leq m < L_r/L_c$, est calculée à l'étape 33 selon :

$$C(n,m) = \frac{\left|\sum_{k=0}^{L_{Sc}-1} r_{k+n+mL_c} \cdot x_k^{c*}\right|^2}{\sum_{k=0}^{L_{Sc}-1} \left|r_{k+n+mL_c}\right|^2 \times E_c} \qquad (10)$$

La corrélation est normalisée par le produit des énergies du signal reçu et du signal

$$x^c \ (E_c = \sum_{k=0}^{L_{Sc}-1} \left|x_k^c\right|^2 ).$$

Cette normalisation permet de s'affranchir des problèmes de changement de dynamique du signal reçu (lors d'un évanouissement, par exemple). L'unité de synchronisation 20 détermine à l'étape 33 la position du maximum de la matrice de corrélations ainsi calculée :

$$(n_{max}, m_{max}) = \underset{(n,m)}{\operatorname{argmax}}[C(n,m)] \qquad (11)$$

$n_{max}$ représente une première estimation du décalage modulo $L_c$, et $m_{max}$ le numéro du motif qui donne ce maximum. A ce stade, comme on n'a repéré qu'un seul des motifs courts, la synchronisation trame n'est pas encore connue. La première estimation $n_{max}$ n'est précise qu'à un échantillon près.

2.2.2) Levée de l'ambiguïté du modulo $L_c$

On cherche à présent une approximation du décalage en nombre d'entiers d'échantillons. Les décalages possibles sont donc de la forme $n_{max}$ + p.$L_c$, où p est un entier positif ou nul. On teste donc ces positions en calculant, à l'étape 34, les corrélations entre le motif long $x^l$ et le signal à partir de ces points, pour $0 \le p < L_r/L_c$ :

$$C_l(p) = \frac{\left|\sum_{k=0}^{L_l-1} r_{k+n_{max}+pL_c} \cdot x_k^{l*}\right|^2}{\sum_{k=0}^{L_l-1} \left|r_{k+n_{max}+pL_c}\right|^2 \times E_l} \qquad (12)$$

$$E_l = \sum_{k=0}^{L_l-1} \left|x_k^l\right|^2$$

est l'énergie du motif long. Les corrélations $C_l(p)$ sont normalisées et comprises entre 0 et 1. On note pos_l la position correspondant au maximum des corrélations $C_l(p)$ avec le motif long, qui est de la forme :

$$pos_l = n_{max} + L_c.p_{max},$$

où

$$p_{max} = \underset{p}{\operatorname{argmax}}[C_l(p)]$$

est l'indice donnant la corrélation maximale.

A l'étape 34, l'unité de synchronisation 20 déduit le décalage temporel cherché $\tau$, exprimé en nombre d'échantillons, de la position du motif long, en supprimant la partie correspondant aux motifs courts :

$$n_{est} = pos_l - N_c \times L_c.$$

On peut ajouter à cette estimation une information supplémentaire : la qualité de la synchronisation, qui est définie comme le maximum $Q = C_l(p_{max})$ des modules des corrélations $C_l(p)$. L'information de qualité Q se rapporte la vraisemblance de l'estimée.

Ceci procure un test pour juger de la fiabilité du processus de synchronisation : si la qualité Q n'est pas supérieure à un seuil donné SQ, on peut décider que la synchronisation a échoué sur la fenêtre de signal courante, et de recommencer le processus de synchronisation sur une autre observée. A titre d'exemple, on peut prendre SQ ≈ 0,35. Ce test est effectué à l'étape 35 de la figure 4. S'il n'est pas satisfait ($Q < SQ$), la synchronisation échoue, et l'unité de synchronisation 20 commande simplement l'oscillateur 18 pour qu'il prenne (éventuellement) en compte la correction de fréquence représentée par l'estimation grossière $\Delta f_1$ pour la prochaine fenêtre d'observation du signal (étape 40). Sinon, l'unité 20 passe aux phases suivantes du procédé, dans lesquelles elle affine la synchronisation.

Lorsque le décalage temporel $\tau$ est limité pour des considérations matérielles à une valeur $\tau_{max}$ faible devant la durée d'un symbole, il est à noter que le segment de référence peut se composer seulement d'une succession de motifs courts de durée égale ou supérieure à $\tau_{max}$. La levée de l'ambiguïté de la longueur du motif court n'est alors plus nécessaire. En outre, on peut alors utiliser un grand nombre de motifs courts, ce qui permet d'améliorer la précision de la synchronisation temporelle fine exposée ci-après.

2.3) Synchronisation temporelle fine

La valeur précédente $n_{est}$ est une approximation du décalage $\tau$ en nombre d'échantillons. La précision de l'estimation peut être augmentée grâce à un calcul utilisant la dérivée du signal de référence. On utilise ici la succession de motifs courts, car le calcul effectué est non-cohérent, et la répétition de ces motifs améliore sensiblement la performance de l'estimation fine.

On note $dx^c$ la dérivée numérique du motif court $x^c$, de longueur $L_{Sc}$-1. La position du début du motif court $x^c$ est à présent connue (à une précision d'un échantillon près). L'unité de synchronisation 20 affine l'estimation de $\tau$ à l'étape 36 en ajoutant à $n_{est}$ la quantité $\Delta\tau$ calculée selon la relation (4) donnée plus haut, le facteur de normalisation $\lambda$ de la relation (5) ayant été calculé une fois pour toutes et mémorisé dans l'unité 20.

On note que l'éventuel décalage en fréquence résiduel n'a pas d'influence sur le calcul de $\Delta\tau$. Ce calcul conduit à estimer le décalage $\tau$ en

$$\text{secondes : } \tau = \frac{n_{est} + \Delta\tau}{F_e}.$$

L'estimation affinée $\tau$ permet d'optimiser les performances du démodulateur de Viterbi 21.

3) SYNCHRONISATION FREQUENTIELLE FINE

On suppose dans la suite que l'unité de synchronisation 20 du récepteur a préalablement acquis la synchronisation temporelle sur l'émetteur à la résolution des échantillons (le calcul de $n_{est}$ suffit donc). Le principe de la synchronisation fréquentielle fine selon l'invention est de multiplier point à point le signal reçu par le conjugué du signal attendu, convenu entre l'émetteur et le récepteur, ce qui aura pour effet d'éliminer du résultat la phase de la modulation. Si de surcroît la modulation est à enveloppe constante, ce résultat sera simplement une sinusoïde (complexe) noyée dans le bruit du récepteur. On peut alors estimer la fréquence de cette sinusoïde, qui sera retirée de la fréquence de l'oscillateur 18 du récepteur, et/ou exploitée dans un traitement numérique, notamment de correction de fréquence.

Ce procédé fonctionne également dans le cas d'une modulation où l'amplitude n'est pas constante, car au lieu d'avoir une sinusoïde, on a une sinusoïde modulée en amplitude : il y a toujours une raie à la fréquence centrale.

On emploie ci-après le formalisme habituel des espaces de Hilbert (ici celui des vecteurs complexes de dimension N), et on utilisera donc le produit scalaire entre 2 vecteurs $x = (x_0, x_1, ..., x_{n-1})^T$ et $y = (y_0, y_1, ..., y_{n-1})^T$ :

$$\langle x, y \rangle = \sum_{n=0}^{N-1} x_n \cdot y_n^* \qquad (13)$$

ainsi que la norme d'un vecteur $x = (x_0, x_1, ..., x_{n-1})^T$ :

$$\|x\| = \sqrt{\langle x, x \rangle} = \sqrt{\sum_{n=0}^{N-1} |x_n|^2} \qquad (14)$$

Le critère dont va découler la méthode décrite ci-après est celui du maximum de vraisemblance.

Soit N le nombre d'échantillons permettant de représenter le signal reçu. Ce nombre N peut être égal ou inférieur au nombre N' d'échantillons du segment de référence. Pour la mise en oeuvre de la méthode, qui utilise une transformée en fréquence telle qu'une transformée de Fourrier Rapide (TFR), N sera de préférence une puissance de 2, ou du moins une valeur autorisant un calcul commode de TFR. Dans l'exemple considéré, N = 128 convient.

On a acquis à ce stade les paramètres de synchronisation temporelle, de sorte qu'on connaît parfaitement

la forme du signal attendu. Le canal de propagation et l'écart de porteuse restent inconnus. On désigne par s = ($s_0$, $s_1$, ..., $s_{n-1}$)$^T$ le signal émis en bande de base (x) décalé d'une fréquence Δf. La densité de probabilité du signal reçu, conditionnellement à l'émission du signal x, s'écrit :

$$p(r|x) = \frac{1}{(\pi\Sigma^2)^N} \exp\left(-\frac{1}{\Sigma^2}\sum_{n=0}^{N-1}\left|r_n - C.x_n.e^{2j\pi.\Delta f.n/F_e}\right|^2\right) \qquad (15)$$

où $\Sigma^2$ est la puissance du bruit b(t) de la relation (6), supposé gaussien. La vraisemblance sera maximale si la somme Θ(Δf, C) dans l'exponentielle est minimale, soit :

$$\begin{aligned}\Theta(\Delta f, C) &= \sum_{n=0}^{N-1}\left|r_n - C.x_n.e^{2j\pi.\Delta f.n/F_e}\right|^2 \\ &= \|r - C.s\|^2 \\ &= \|r\|^2 + |C|^2.\|s\|^2 - 2.\mathrm{Re}\left(C^*.\langle r, s\rangle\right)\end{aligned} \qquad (16)$$

La solution du problème est donc le couple (C, Δf) qui annule la différentielle de la fonction Θ. La dérivée $\frac{\partial\Theta}{\partial C}$ = 2.C. $\|s\|^2$-2.⟨r,s⟩ s'annule pour C = $\frac{\langle r, s\rangle}{\|s\|^2}$. On obtient donc l'expression plus simple:

$$\Theta = \|r\|^2 - \frac{|\langle r, s\rangle|^2}{\|s\|^2}.$$

Dans la suite, on supposera que la modulation employée est à enveloppe constante (normalisée à 1), et donc le signal s aussi. Par conséquent, le carré de la norme de s est égal au nombre d'échantillons N, et l'expression de Θ se simplifie encore :

$$\Theta = \|r\|^2 - \frac{|\langle r, s\rangle|^2}{N}.$$

Comme s est seul à dépendre de Δf, Θ est minimale lorsque $|\langle r,s\rangle|^2$ est maximal. Cette dernière quantité peut être interprétée lorsqu'on en développe l'expression :

$$|\langle r, s\rangle|^2 = \left|\sum_{n=0}^{N-1} r_n.s_n^*\right|^2 = \left|\sum_{n=0}^{N-1}\left(r_n.x_n^*\right)e^{-2j\pi.\Delta f.n/F_e}\right|^2 \qquad (17)$$

Il s'agit donc du module au carré de la transformée de Fourier discrète (TFD) du signal r,x*, signal que l'on nommera y dans la suite. Sa transformée de Fourier est notée Y(f).

On peut alors élaborer une stratégie, pour estimer Δf, basée sur une transformée de Fourier du signal y. L'étape 37 d'estimation fine de Δf commence donc par le calcul du vecteur y ($y_n = r_n. x^*_n$ pour $0 \le n < N$), et par le calcul de sa TFD grâce à un algorithme standard de TFR complexe. Ensuite, l'unité 20 recherche, parmi les fréquences « naturelles » de cette TFR, celle $f_{max}$ qui rend le module carré de cette TFR maximum. La TFR est définie en un nombre N de fréquences, ou points, $f_i$ données par $f_i = \frac{i.F_e}{N}$, pour $0 \le i < N$.

Bien entendu, la recherche du maximum

$$f_{max} = \underset{0 \le i < N}{\text{argmax}}\, Y(f_i)$$

ne donnera pas exactement la solution attendue, car il n'y a aucune raison pour que $\Delta f$ soit précisément égal à une des fréquences $f_i$ de la TFR. On va ensuite affiner le calcul. Les principes sur lesquels repose cette détermination plus précise sont, d'une part, le fait que la transformée de Fourier d'un signal tronqué vaut la transformée de Fourier de ce même signal convoluée avec un sinus cardinal, et d'autre part une approximation de type moindres carrés d'une TFR par un sinus cardinal.

La transformée de Fourier discrète $S_c(f)$ d'une séquence de « 1 » finie de longueur N a pour module un sinus cardinal :

$$\begin{aligned} S_c(f) = \sum_{i=0}^{N-1} e^{-2j\pi.f.i/F_e} &= \sum_{i=0}^{N-1} \left(e^{-2j\pi.f/F_e}\right)^i \\ &= \frac{1-\exp(-2j\pi Nf/F_e)}{1-\exp(-2j\pi f/F_e)} \\ &= e^{-j\pi(N-1)f/F_e}.\frac{\sin(\pi fN/F_e)}{\sin(\pi f/F_e)} \end{aligned} \qquad (18)$$

La transformée de Fourier discrète d'un signal tronqué à N échantillons est la convolution de la transformée de Fourier discrète de ce signal non tronqué par la fonction $S_c(f)$.

Le signal y précité est en principe une sinusoïde complexe affectée d'un coefficient complexe C rendant compte de la propagation, plus du bruit, à savoir :

$$y_n = C.e^{2j\pi,\Delta f.N/F_e} + b_n.$$

Sa transformée de Fourier discrète est alors :

$$Y(f) = C.S_c(f-\Delta f) + B(f) = C.e^{-2j\pi(N-1)(f-\Delta f)/F_e}.\frac{\sin(\pi N(f-\Delta f)/F_e)}{\sin(\pi(f-\Delta f)/F_e)} + B(f) \qquad (19)$$

On cherche alors C et $\Delta f$ qui permettent d'approcher Y(f) au mieux par une fonction $C.S_c(f-\Delta f)$, au sens des moindres carrés, c'est-à-dire pour lesquelles le coût $K(C,\Delta f)=\|Y(f)-C.S_c(f-\Delta f)\|^2$ est minimum. Par un calcul similaire à celui présenté plus haut, on trouve que la solution pour C est

$$C = \frac{\langle Y(f), S_c(f-\Delta f)\rangle}{\|S_c(f-\Delta f)\|^2}$$

, de sorte que la fonction coût que $\Delta f$ doit minimiser est celle donnée par la relation (3).

Dans l'expression de K et de C, les calculs sont faits dans l'espace des fonctions de carré sommable. En utilisant le fait que la norme de $S_c$ est indépendante de $\delta f$, on montre que la valeur optimale $\Delta f$ annule la fonction $F(\delta f)$ de la relation (1).

Sur la base du signal reçu $r_n$, l'unité 20 détermine Y(f), échantillonnée aux fréquences $f_i$. Elle mémorise d'autre part les valeurs de $S_c(f-\delta f)$ et de sa dérivée par rapport à $\delta f$, échantillonnées avec la résolution souhaitée pour l'estimation de $\Delta f$. Les produits scalaires continus des formules (1 ) et (3) sont donc naturellement remplacés par des produits scalaires discrets selon la relation (2), soit par exemple :

$$\langle Y(f), S_c(f-\delta f)\rangle \cong \sum_{n=0}^{N-1} Y(f_i).S_c(f_i-\delta f) \qquad (20)$$

La dernière étape de la méthode est la recherche de $\Delta f$ qui annule $F(\delta f)$, ou de la valeur « trouvable » en pratique qui rend $F(\delta f)$ le plus proche possible de 0.

Une technique possible est une recherche dichotomique sur un ensemble prédéfini de valeurs de $\delta f$. On montre que la fonction de coût $K(\delta f)$ possède, en plus du minimum absolu en $\Delta f$, une série de minima locaux distants de $\Delta f$ de multiples de $F_e/N$, qui se traduisent par des valeurs nulles de la fonction F. Il faut donc prendre garde à ne pas converger vers un de ces minima locaux. Pour cela, on note que la fréquence naturelle $f_{max}$ pour laquelle $|Y(f)|^2$ est maximum donne une indication sur la vraie valeur de $\Delta f$ avec une erreur valant au plus $F_e/N$ (la résolution fréquentielle de la TFR employée). Par conséquent, si on cherche $\Delta f$ autour de cette première valeur, il y a un risque de trouver une valeur fausse de $\pm F_e/N$ par rapport à la vraie valeur (cela dépend de la résolution en fréquence de la TFR et de l'emplacement de $f_{max}$ par rapport à $\Delta f$), mais pas au-delà.

Une solution peut alors être de diviser l'intervalle $[f_{max} - F_e/N, f_{max} + F_e/N]$ en trois sous-intervalles $[f_{max} - F_0/N, f_{max} - F_e/3N]$, $[f_{max} - F_e/3N, f_{max} + F_e/3N]$ et $[f_{max} + F_e/3N, f_{max} + F_e/N]$, et d'effectuer une recherche dichotomique dans chacun des sous-intervalles. Ceci assure de ne pas manquer le minimum absolu. On garantit en outre la convergence de la méthode dichotomique, pour laquelle il faut qu'il y ait au plus un seul passage par zéro de la fonction F à annuler. Parmi les trois valeurs trouvées pour $\Delta f$, on retient celle qui rend le coût K minimal. Pour méthodes autres que la dichotomie, qui toléreraient l'existence de plusieurs minima, la recherche pourrait se faire sur la réunion des trois intervalles précédents.

Cette estimation fine de $\Delta f$ est effectuée par l'unité de synchronisation 20 à l'étape 37 de la figure 4. Si une correction de fréquence numérique, (multiplication du signal complexe non filtré par $e^{-2j\pi\Delta f}$), est prévue en amont du filtre 19, celle-ci peut être effectuée sur la fenêtre de signal courante afin d'optimiser la représentativité du signal en bande de base $r_n$ (étape 38 de la figure 4). Sinon (cas illustré par la figure 3), la valeur estimée de $\Delta f$ est prise en compte pour les fenêtres suivantes par rectification analogique de la fréquence de l'oscillateur 18, afin de corriger les dérives de cette fréquence (ou de celle utilisée par l'émetteur).

A l'étape 39, l'unité 20 fournit le décalage temporel estimé $\tau$ au démodulateur 21, afin de l'aligner sur la structure temporelle des trames et des symboles.

Finalement, à l'étape 40, l'unité 20 fournit le décalage fréquentiel estimé $\Delta f$ aux circuits de contrôle de l'oscillateur 18, afin qu'ils corrigent l'écart avec la fréquence employée par l'émetteur.

On a mentionné que la correction de la fréquence de l'oscillateur 18 pouvait n'être qu'éventuelle lorsque le segment de référence n'a pas été détecté (test 32 ou 35). Cette correction ne doit pas être appliquée systématiquement s'il n'y a pas de garantie que le segment de référence, lorsqu'il est bien présent, se trouve entièrement dans une fenêtre d'observation du signal (il peut par exemple se trouver à cheval sur deux fenêtres consécutives). La correction de fréquence grossière peut donc être conditionnée lorsque le test 32 ou 35 est négatif. On peut par exemple choisir de n'effectuer cette correction que périodiquement, avec une fréquence assez peu élevée afin de laisser plusieurs paquets d'échantillons consécutifs avec le même écart de fréquence. En choisissant la période et celle de répétition du segment de référence, exprimées en nombres de trames, de telle sorte qu'elles soient premières entre elles, on se prémunit contre le cas pathologique où on appliquerait systématiquement la correction de fréquence pile sur le segment de signal connu.

Une autre solution consisterait à ne corriger la fréquence de l'oscillateur que si l'estimation courante de $\Delta f$ dépasse un seuil déterminé après la dernière application de la correction. Ceci permet une correction rapide d'un fort écart initial.

Des simulations ont été effectuées dans le cas de l'exemple numérique donné ci-dessus à titre d'illustration, en prenant en compte trois critères :

- la probabilité de non détection du segment de référence (échec de l'algorithme au test 32 ou 35 ;
- la probabilité de mauvaise synchronisation temporelle, à 0,25 temps symbole près ;
- la probabilité de mauvaise synchronisation fréquentielle, à 50 Hz près.

Le Tableau I montre les résultats obtenus dans deux conditions de simulation :

A/ en présence de bruit sans distorsion due au canal, pour un rapport signal-sur-bruit de 5 dB ;
B/ en présence de bruit et de fading de Rayleigh sur le canal, pour un rapport signal-sur-bruit de 20 dB et une vitesse de 50 km/h.

TABLEAU I

| cas | probabilité de non détection | probabilité de mauvaise synchronisation temporelle | probabilité de mauvaise synchronisation fréquentielle |
|---|---|---|---|
| A | $10^{-3}$ | $2.\ 10^{-3}$ | $< 10^{-3}$ |
| B | $1{,}2.\ 10^{-2}$ | $6.\ 10^{-3}$ | $7.\ 10^{-3}$ |

## Revendications

**1.** Procédé de synchronisation d'un récepteur de communication, dans lequel on évalue un écart entre une fréquence de modulation, combinée à un premier signal en bande de base pour former un signal émis sur un canal de propagation et une fréquence employée par le récepteur pour former un second signal en bande de base ($r_n$) à partir d'un signal reçu sur le canal de propagation, et on corrige la fréquence employée par le récepteur en fonction de l'écart évalué, **caractérisé en ce que**, connaissant un segment temporel du premier signal en bande de base et la position temporelle d'un segment correspondant du second signal en bande de base, lesdits segments comprenant N échantillons à une fréquence d'échantillonnage $F_e$, on calcule une transformée en fréquence Y(f), de taille N, du produit du complexe conjugué dudit segment du premier signal en bande de base par le segment correspondant du second signal en bande de base, et on évalue ledit écart de fréquence $\Delta f$ comme étant celui pour lequel la transformée en fréquence Y(f) est la plus proche de $C.S_c(f-\Delta f)$, où $S_c(f)$ est la fonction

$$S_c(f) = \frac{1-\exp(-2j\pi Nf/F_e)}{1-\exp(-2j\pi f/F_e)},$$

et C est un coefficient complexe.

**2.** Procédé selon la revendication 1, dans lequel l'évaluation dudit écart de fréquence comprend :

- la détermination d'une fréquence $f_{max}$ qui maximise la quantité $|Y(f)|^2$ parmi les N points de la transformée en fréquence ;
- une division de l'intervalle $[f_{max}- F_e /N, f_{max} + F_e /N]$ en plusieurs sous-intervalles ;
- une recherche dichotomique dans chacun des sous-intervalles pour identifier chaque fréquence $\delta f$ qui annule la quantité

$$F(\delta f) = \mathrm{Re}\left\{\left\langle Y(f), S_c(f-\delta f)\right\rangle^{*} . \left\langle Y(f), \frac{\partial S_c(f-\delta f)}{\partial(\delta f)}\right\rangle\right\}$$

où, pour deux fonctions complexes de la fréquence A(f) et B(f), $\langle A(f),B(f-\delta f)\rangle$ désigne le produit scalaire

$$\left\langle A(f),B(f-\delta f)\right\rangle = \sum_{i=0}^{N-1} A(f_i).B(f_i-\delta f)^{*},$$

$f_i$ désignant le point de rang i de la transformée en fréquence ; et
- la sélection de l'écart de fréquence $\Delta f$ comme étant celle des fréquences $\delta f$ qui annule la quantité $F(\delta f)$ et pour laquelle la fonction coût

$$K(\delta f) = \left\| Y(f) - \frac{\langle Y(f), S_c(f-\delta f)\rangle . S_c(f-\delta f)}{\|S_c(f-\delta f)\|^2} \right\|^2$$

est minimale, $\|.\|$ étant la norme associée audit produit scalaire.

**3.** Procédé selon la revendication 1 ou 2, dans lequel ledit segment temporel du premier signal en bande de base est connu a priori par le récepteur, le procédé comprenant une phase de synchronisation temporelle (32-36) pour obtenir la position temporelle dudit segment du second signal en bande de base ($r_n$).

**4.** Procédé selon la revendication 3, dans lequel ledit segment temporel du premier signal en bande de base comprend plusieurs occurrences consécutives d'un premier motif d'échantillons ($x^c$).

**5.** Procédé selon la revendication 4, dans lequel la phase de synchronisation temporelle comprend un test de répétition (32) au cours duquel on évalue une autocorrélation normalisée du second signal en bande de base ($r_n$) relativement à un décalage temporel correspondant au décalage ($L_c$) entre deux occurrences du premier motif ($x^c$) dans le segment temporel du premier signal en bande de base.

**6.** Procédé selon la revendication 4 ou 5, dans lequel ledit segment temporel du premier signal en bande de base comprend un second motif d'échantillons ($x^l$), plus long que le premier motif ($x^c$), en plus des occurrences consécutives du premier motif.

**7.** Procédé selon la revendication 6, dans lequel la phase de synchronisation temporelle comprend une étape (33) d'estimation modulo $L_c$ par maximisation de corrélation ($C(n,m)$) entre le second signal en bande de base ($r_n$) et les occurrences consécutives du premier motif ($x^c$), $L_c$ étant le nombre d'échantillons du premier motif, et une étape (34) de levée d'ambiguïté du modulo $L_c$, fournissant une synchronisation temporelle à la résolution des échantillons par maximisation de corrélation ($C_l(p)$) entre le second signal en bande de base et le second motif ($x^l$).

**8.** Procédé selon la revendication 7, dans lequel on produit une estimation (Q) de qualité de la synchronisation temporelle sur la base de la corrélation maximisée ($C_l(p_{max})$) entre le second signal en bande de base ($r_n$) et le second motif ($x^l$).

**9.** Procédé selon l'une quelconque des revendications 4 à 8, dans lequel on réalise une première synchronisation temporelle (32-35) produisant un nombre entier $n_{est}$ représentant un décalage temporel, en nombre d'échantillons, du second signal en bande de base ($r_n$) par rapport audit segment temporel du premier signal en bande de base, et on affine la première synchronisation temporelle en ajoutant au nombre entier $n_{est}$ la quantité :

$$\Delta\tau = 1 - \lambda . \frac{\mathrm{Re}\left\{ \sum_{q=0}^{N_c-1} \left[ \left( \sum_{k=0}^{L_{Sc}-1} r_{n_{est}+q.L_c+k} . x_k^{c*} \right) . \left( \sum_{k=0}^{L_{Sc}-2} r_{n_{est}+q.L_c+k}^{*} . dx_k^c \right) \right] \right\}}{\sum_{q=0}^{N_c-1} \left\| \sum_{k=0}^{L_{Sc}-1} r_{n_{est}+q.L_c+k} . x_k^{c*} \right\|^2},$$

où $\lambda$ est le facteur de normalisation :

$$\lambda = \frac{\left(\sum_{k=0}^{L_{Sc}-1} \left|x_k^c\right|^2\right)^2}{\left(\sum_{k=0}^{L_{Sc}-1} \left|x_k^c\right|^2\right)\left(\sum_{k=0}^{L_{Sc}-1} \left|dx_k^c\right|^2\right) - \left[\mathrm{Im}\left(\sum_{k=0}^{L_{Sc}-1} x_k^c . dx_k^{c*}\right)\right]^2},$$

$N_c$ est le nombre d'occurrences consécutives du premier motif ($x^c$), $L_{Sc}$ est le nombre d'échantillons de la séquence répétitive formée par les occurrences consécutives du premier motif dans ledit segment temporel du premier signal en bande de base, $r_{n_{est}+q.L_c+k}$ est l'échantillon de rang $n_{est}$+q.$L_c$+k du second signal en bande de base, $x_k^c$ est l'échantillon de rang k de ladite séquence répétitive, et $dx_k^c$ est l'échantillon de rang k d'une séquence formée par la dérivée temporelle de ladite séquence répétitive.

**10.** Procédé selon !'une quelconque des revendications 1 à 9, comprenant une étape initiale (30) de synchronisation fréquentielle grossière sur la base de l'argument d'une autocorrélation du second signal en bande de base.

**11.** Dispositif de synchronisation d'un récepteur de communication, comprenant des moyens (20) d'analyse d'un signal reçu ($r_n$), agencés pour mettre en oeuvre un procédé de synchronisation selon l'une quelconque des revendications 1 à 10.

## Claims

**1.** A method of synchronising a communication receiver, comprising the steps of evaluating a deviation between a modulation frequency, combined with a first baseband signal to form a signal transmitted on a propagation channel and a frequency used by the receiver to form a second baseband signal ($r_n$) from a signal received on the propagation channel, and adjusting the frequency used by the receiver according to the evaluated deviation, **characterised in that**, knowing a time segment of the first baseband signal and the time position of a corresponding segment of the second baseband signal, said segments comprising N samples at a sampling frequency $F_e$, a frequency transform Y(f), of size N, of the product of the complex conjugate of said segment of the first baseband signal by the corresponding segment of the second baseband signal is calculated, and said frequency deviation $\Delta f$ is evaluated as being that for which the frequency transform Y(f) is the closest to $C.S_c(f-\Delta f)$, where $S_c(f)$ is the function

$$S_c(f) = \frac{1-\exp(-2j\pi Nf/F_e)}{1-\exp(-2j\pi f/F_e)}$$

, and C is a complex coefficient.

**2.** Method according to claim 1, wherein the step of evaluating said frequency deviation comprises:

- determining a frequency $f_{max}$ which maximises the quantity $|Y(f)|^2$ among the N points of the frequency transform;
- dividing the interval $[f_{max} - F_e/N, f_{max} + F_e/N]$ into a plurality of sub-intervals;
- a dichotomic search in each of the sub-intervals to identify each frequency $\delta f$ which cancels out the quantity

$$F(\delta f) = \mathrm{Re}\left\{\left\langle Y(f), S_c(f-\delta f)\right\rangle^* . \left\langle Y(f), \frac{\partial S_c(f-\delta f)}{\partial(\delta f)}\right\rangle\right\}$$

where, for two complex functions of the frequency A(f) and B(f), $\langle A(f),B(f-\delta f)\rangle$ designates the inner product

$$\langle A(f),B(f-\delta f)\rangle = \sum_{i=0}^{N-1} A(f_i).B(f_i-\delta f)^* ,$$

$f_i$ designating the point of rank i of the frequency transform; and

- selecting the frequency deviation $\Delta f$ as being that of the frequencies $\delta f$ which cancels out the quantity $F(\delta f)$ for which the cost function

$$K(\delta f) = \left\| Y(f) - \frac{\langle Y(f), S_c(f-\delta f)\rangle . S_c(f-\delta f)}{\|S_c(f-\delta f)\|^2} \right\|^2$$

is minimal; $\|.\|$ being the norm associated with said inner product.

3. Method according to claim 1 or 2, wherein said time segment of the first baseband signal is known *a priori* by the receiver, the method including a time synchronisation phase (32-36) for obtaining the time position of said segment of the second baseband signal ($r_n$).

4. Method according to claim 3, wherein said time segment of the first baseband signal includes several consecutive occurrences of a first sample pattern ($x^c$).

5. Method according to claim 4, wherein the time synchronisation phase includes a repetition test (32) in which a normalised autocorrelation of the second baseband signal ($r_n$) is evaluated with respect to a time difference corresponding to the difference ($L_c$) between two occurrences of the first pattern ($x^c$) in the time segment of the first baseband signal.

6. Method according to claim 4 or 5, wherein said time segment of the first baseband signal includes a second sample pattern ($x^l$), longer than the first pattern ($x^c$), in addition to the consecutive occurrences of the first pattern.

7. Method according to claim 6, wherein the time synchronisation phase includes a modulo $L_c$ estimation step (33) by maximising a correlation (C(n,m)) between the second baseband signal ($r_n$) and the consecutive occurrences of the first pattern ($x^c$), $L_c$ being the number of samples of the first pattern, and a modulo $L_c$ ambiguity removing step (34), supplying a time synchronisation at the resolution of the samples by maximising a correlation (C,(p)) between the second baseband signal and the second pattern ($x^l$).

8. Method according to claim 7, further comprising the step of producing a quality estimate (Q) of the time synchronization on the basis of the maximised correlation ($C_l(p_{max})$) between the second baseband signal ($r_n$) and the second pattern ($x^l$).

9. Method according to any one of claims 4 to 8, further comprising the step of carrying out a first time synchronisation (32-35) producing a whole number $n_{est}$ representing a time difference, in number of samples, of the second baseband signal ($r_n$) with respect to said time segment of the first baseband signal, and refining the first time synchronisation by adding to the whole number $n_{est}$ the quantity:

$$\Delta\tau = 1-\lambda.\frac{\mathrm{Re}\left\{\sum_{q=0}^{N_c-1}\left[\left(\sum_{k=0}^{L_{Sc}-1} r_{n_{est}+q.L_c+k}\cdot x_k^{c*}\right)\cdot\left(\sum_{k=0}^{L_{Sc}-2} r^{*}_{n_{est}+q.L_c+k}\cdot dx_k^{c}\right)\right]\right\}}{\sum_{q=0}^{N_c-1}\left\|\sum_{k=0}^{L_{Sc}-1} r_{n_{est}+q.L_c+k}\cdot x_k^{c*}\right\|^2},$$

where λ is the normalisation factor:

$$\lambda = \frac{\left(\sum_{k=0}^{L_{Sc}-1}\left|x_k^c\right|^2\right)^2}{\left(\sum_{k=0}^{L_{Sc}-1}\left|x_k^c\right|^2\right)\cdot\left(\sum_{k=0}^{L_{Sc}-1}\left|dx_k^c\right|^2\right)-\left[\mathrm{Im}\left(\sum_{k=0}^{L_{Sc}-1} x_k^c.dx_k^{c*}\right)\right]^2},$$

$N_c$ is the number of consecutive occurrences of the first pattern ($x^c$), $L_{Sc}$ is the number of samples of the repetitive sequence formed by the consecutive occurrences of the first pattern in said time segment of the first baseband signal, $r_{n_{est}+q.L_c+k}$ is the sample of rank $n_{est}+q.L_c+k$ of the second baseband signal, $x_k^c$ is the sample of rank k of said repetitive sequence, and $dx_k^c$ is the sample of rank k of a sequence formed by the time derivative of said repetitive sequence.

10. Method according to any one of claims 1 to 9, further comprising an initial step (30) of rough frequency synchronisation based on the argument of an autocorrelation of the second baseband signal.

11. A synchronisation device for a communication receiver, comprising means (20) of analysing a received signal ($r_n$), arranged for implementing a synchronisation method according to any one of claims 1 to 10.

**Patentansprüche**

1. Verfahren zum Synchronisieren eines Kommunikationsempfängers, bei dem ein Abstand zwischen einer Modulationsfrequenz, die mit einem ersten Grundbandsignal kombiniert ist, um ein auf einem Übertragungskanal ausgesendetes Signal zu bilden, und einer Frequenz, die von dem Empfänger verwendet wird, um anhand eines auf dem Übertragungskanal empfangenen Signals ein zweites Grundbandsignal ($r_n$) zu bilden, bewertet wird und die von dem Empfänger verwendete Frequenz in Abhängigkeit von dem bewerteten Abstand korrigiert wird, **dadurch gekennzeichnet, dass** dann, wenn ein Zeitsegment des ersten Grundbandsignals und die zeitliche Position eines dem zweiten Grundbandsignal entsprechenden Segments bekannt ist, diese Segmente, die N mit einer Abtastfrequenz $F_e$ abgetastete Werte enthalten, eine Frequenztransformierte Y(f) mit Größe N des Produkts aus der Komplexkonjugierten des Segments des ersten Grundbandsignals und aus dem dem zweiten Grundbandsignal entsprechenden Segment berechnet wird und der Frequenzabstand Δf als jener bewertet wird, für den die Frequenztransformierte Y(f) am nächsten bei $C \cdot S_c(f - \Delta f)$ liegt, wobei $S_c(f)$ die Funktion

$$S_c(f) = \frac{1-\exp(-2j\pi Nf/F_e)}{1-\exp(-2j\pi f/F_e)}$$

ist und C ein komplexer Koeffizient ist.

2. Verfahren nach Anspruch 1, bei dem die Bewertung des Frequenzabstandes umfasst:

- Bestimmen einer Frequenz $f_{max}$, die die Größe $|Y(f)|^2$ von den N Punkten der Frequenztransformierten maximal macht;
- Unterteilen des Intervalls $[f_{max} - F_e/N, f_{max} + F_e/N]$ in mehrere Unterintervalle;
- dichotomisches Durchsuchen jedes der Unterintervalle, um jede Frequenz $\delta f$ zu identifizieren, für die die Größe

$$F(\delta f) = \mathrm{Re}\left\{\left\langle Y(f), S_c(f-\delta f)\right\rangle^{*} \cdot \left\langle Y(f), \frac{\partial S_c(f-\delta f)}{\partial(\delta f)}\right\rangle\right\}$$

null ist, wobei für zwei komplexe Funktionen der Frequenz A(f) und B(f) $\langle A(f),B(f-\delta f)\rangle$ das Skalarprodukt

$$\left\langle A(f), B(f-\delta f)\right\rangle = \sum_{i=0}^{N-1} A(f_i) . B(f_i-\delta f)^{*}$$

bezeichnet, wobei $f_i$ den Punkt mit Rang i der Frequenztransformierten bezeichnet; und

- Auswählen des Frequenzabstandes $\Delta f$ als jenen der Frequenzen $\delta f$, der die Größe $F(\delta f)$ null macht und für den die Kostenfunktion

$$K(\delta f) = \left\| Y(f) - \frac{\left\langle Y(f), S_c(f-\delta f)\right\rangle . S_c(f-\delta f)}{\left\| S_c(f-\delta f)\right\|^2} \right\|^2$$

minimal ist, wobei $\|\cdot\|$ die dem Skalarprodukt zugeordnete Norm ist.

**3.** Verfahren nach Anspruch 1 oder 2, bei dem das Zeitsegment des ersten Grundbandsignals für den Empfänger im Voraus bekannt ist, wobei das Verfahren eine Phase (32-36) der zeitlichen Synchronisation umfasst, um die zeitliche Position des Segments des zweiten Grundbandsignals ($r_n$) zu erhalten.

**4.** Verfahren nach Anspruch 3, bei dem das Zeitsegment des ersten Grundbandsignals mehrere aufeinander folgende Auftritte eines ersten Abtastmusters ($x^c$) umfasst.

**5.** Verfahren nach Anspruch 4, bei dem die Phase der zeitlichen Synchronisation einen Wiederholungstest (32) umfasst, in dessen Verlauf eine normierte Autokorrelation des zweiten Grundbandsignals ($r_n$) in Bezug auf eine zeitliche Verzögerung, die der Verzögerung ($L_c$) zwischen zwei Auftritten des ersten Musters ($x^c$) in dem Zeitsegment des ersten Grundbandsignals entspricht, bewertet wird.

**6.** Verfahren nach Anspruch 4 oder 5, bei dem das Zeitsegment des ersten Grundbandsignals zusätzlich zu den aufeinander folgenden Auftritten des ersten Musters ein zweites Abtastmuster ($x^l$), das länger als das erste Muster ($x^c$) ist, enthält.

**7.** Verfahren nach Anspruch 6, bei dem die Phase der zeitlichen Synchronisation einen Schritt (33) der Schätzung von Modulo $L_c$ durch Maximieren der Korrelation (C(n, m)) zwischen dem zweiten Grundbandsignal ($r_n$) und den aufeinander folgenden Auftritten des ersten Musters ($x^c$), wobei $L_c$ die Anzahl der Abtastwerte des ersten Musters ist, und einen Schritt (34) des Beseitigens der Mehrdeutigkeit von Modulo $L_c$, der eine zeitliche Synchronisation mit der Auflösung der Abtastwerte durch Maximierung der Korrelation ($C_l(p)$) zwischen dem zweiten Grundbandsignal und dem zweiten Muster ($x^l$) ergibt, umfasst.

**8.** Verfahren nach Anspruch 7, bei dem eine Schätzung (Q) der Qualität der zeitlichen Synchronisation auf der Grundlage der maximierten Korrelation ($C_l(p_{max})$) zwischen dem zweiten Grundbandsignal ($r_n$) und dem zweiten Muster

($x^l$) erzeugt wird.

**9.** Verfahren nach einem der Ansprüche 4 bis 8, bei dem eine erste zeitliche Synchronisation (32-35) verwirklicht wird, die eine ganze Zahl $n_{est}$ ergibt, die eine zeitliche Verzögerung, ausgedrückt durch die Anzahl der Abtastwerte des zweiten Grundbandsignals ($r_n$), in Bezug auf das Zeitsegment des ersten Grundbandsignals repräsentiert, und die erste zeitliche Synchronisation verfeinert wird, indem zu der ganzen Zahl nest die folgende Größe hinzugefügt wird:

$$\Delta\tau = 1 - \lambda \cdot \frac{\mathrm{Re}\left\{\sum_{q=0}^{N_c-1}\left[\left(\sum_{k=0}^{L_{Sc}-1} r_{n_{est}+qL_c+k} \cdot x_k^{c*}\right)\left(\sum_{k=0}^{L_{Sc}-2} r_{n_{est}+qL_c+k}^{*} \cdot dx_k^{c}\right)\right]\right\}}{\sum_{q=0}^{N_c-1}\left\|\sum_{k=0}^{L_{Sc}-1} r_{n_{est}+qL_c+k} \cdot x_k^{c*}\right\|^2}$$

wobei λ der folgende Normierungsfaktor ist:

$$\lambda = \frac{\left(\sum_{k=0}^{L_{Sc}-1}\left|x_k^c\right|^2\right)^2}{\left(\sum_{k=0}^{L_{Sc}-1}\left|x_k^c\right|^2\right)\left(\sum_{k=0}^{L_{Sc}-1}\left|dx_k^c\right|^2\right)-\left[\mathrm{Im}\left(\sum_{k=0}^{L_{Sc}-1} x_k^c . dx_k^{c*}\right)\right]^2}$$

wobei $N_c$ die Anzahl aufeinander folgender Auftritte des ersten Musters ($x^c$) ist, $L_{Sc}$ die Anzahl der Abtastwerte der Wiederholungsfolge ist, die durch die aufeinander folgenden Auftritte des ersten Musters in dem Zeitsegment des ersten Grundbandsignals gebildet wird, $r_{nest+q \cdot Lc+k}$ der Abtastwert mit Rang nest + q · $L_c$ + k des zweiten Grundbandsignals ist, $x_k^c$ der Abtastwert mit Rang k der Wiederholungsfolge ist und $dx_k^c$ der Abtastwert mit Rang k einer Folge ist, die durch die zeitliche Ableitung der Wiederholungsfolge gebildet wird.

**10.** Verfahren nach einem der Ansprüche 1 bis 9, das einen Anfangsschritt (30) einer groben Frequenzsynchronisation auf der Grundlage des Arguments einer Autokorrelation des zweiten Grundbandsignals umfasst.

**11.** Vorrichtung für die Synchronisation eines Kommunikationsempfängers, der Mittel (20) für die Analyse eines empfangenen Signals ($r_n$) umfasst, die so beschaffen sind, dass sie ein Synchronisationsverfahren nach einem der Ansprüche 1 bis 10 ausführen.

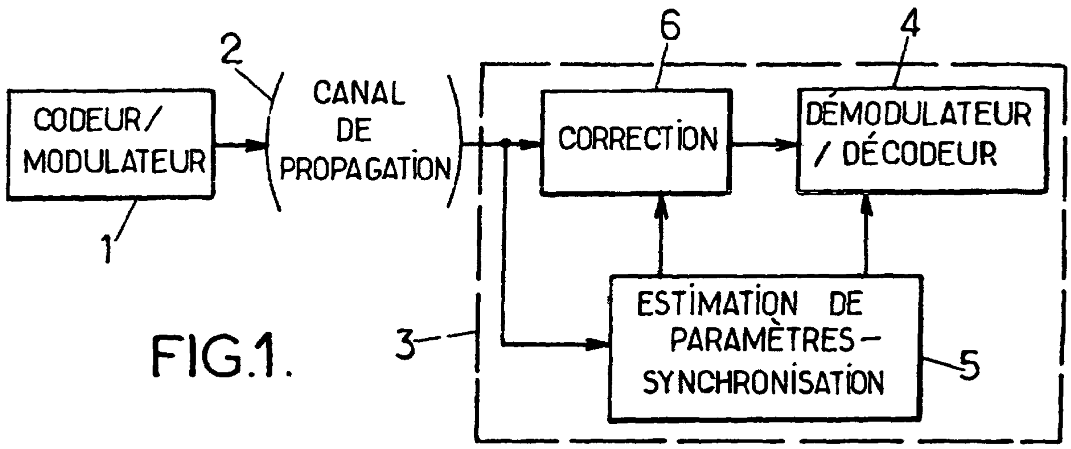


FIG.1.

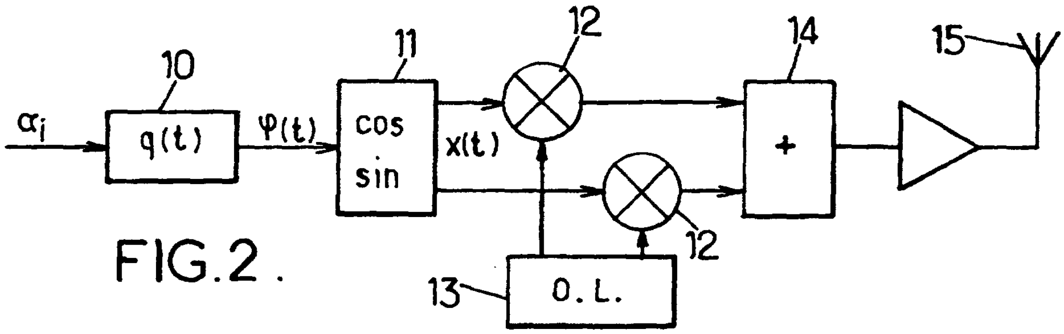


FIG.2.

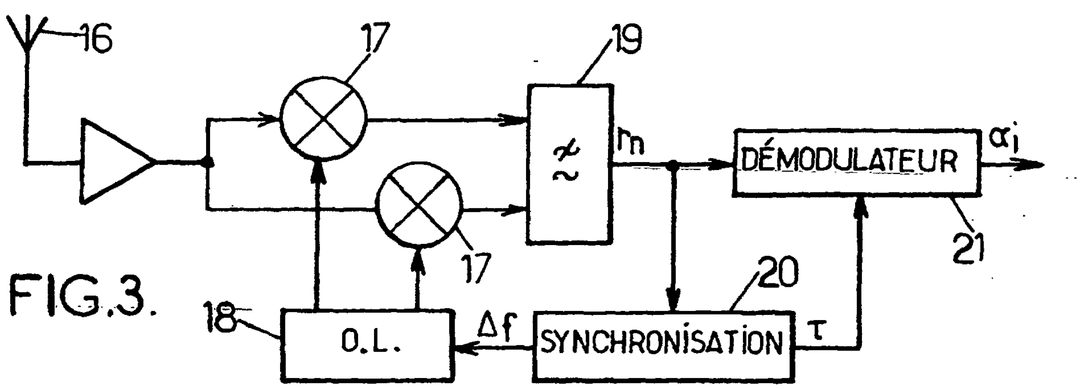


FIG.3.

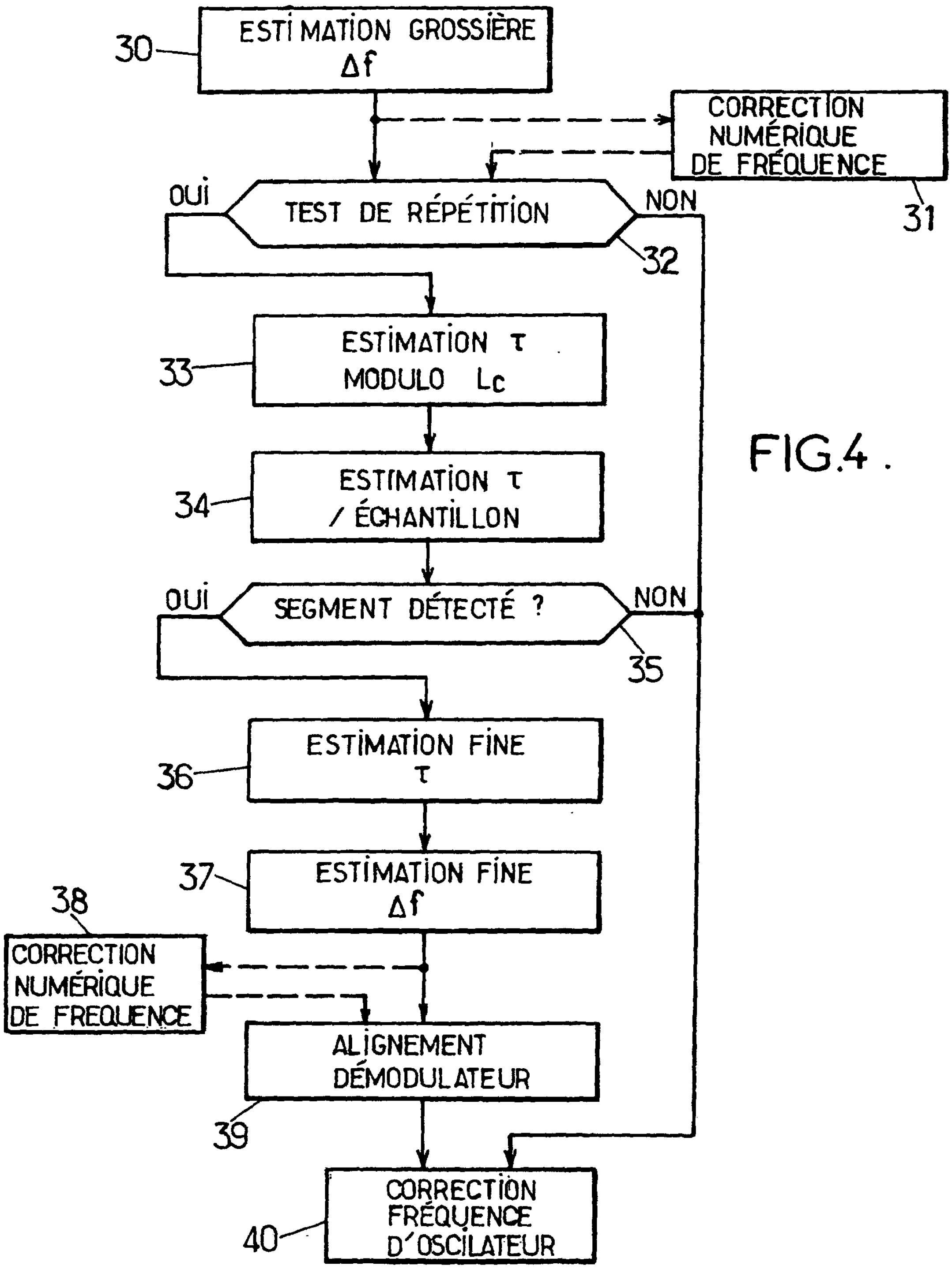
30
ESTIMATION GROSSIÈRE
Δf
CORRECTION
NUMÉRIQUE
DE FRÉQUENCE
31
OUI
TEST DE RÉPÉTITION
NON
32
33
ESTIMATION τ
MODULO Lc
34
ESTIMATION τ
/ ÉCHANTILLON
OUI
SEGMENT DÉTECTÉ ?
NON
35
36
ESTIMATION FINE
τ
37
ESTIMATION FINE
Δf
38
CORRECTION
NUMÉRIQUE
DE FREQUENCE
ALIGNEMENT
DÉMODULATEUR
39
40
CORRECTION
FRÉQUENCE
D'OSCILATEUR

FIG.4.